# EUROPEAN PATENT SPECIFICATION

(11) **EP 0 901 233 B1**
(45) Date of publication and mention of the grant of the patent: **02.03.2005**
(21) Application number: 97830440.0
(22) Date of filing: 05.09.1997
(51) Int. Cl.: H03M 3/00, H03M 3/02

(54) **Double sampled sigma delta modulator of second order having a semi-bilinear architecture**
Sigma Delta-Modulator zweiter Ordnung mit doppelter Abtastung und semi-bilinearer Architektur
Modulateur du type sigma delta d'ordre deux à double échantillonnage présentant une architecture semi-bilinéaire

(43) Date of publication of application: 10.03.1999
(73) Proprietor: STMicroelectronics S.r.l., 20041 Agrate Brianza (Milano) (IT)
(72) Inventor: Nagari, Angelo, 27024 Cilavegna (IT); Nicollini, Germano, 29100 Piacenza (IT)
(74) Representative: Pellegri, Alberto

(56) References cited:
- US-A- 5 392 043
- BURMAS T V ET AL: "A SECOND-ORDER DOUBLE-SAMPLED DELTA-SIGMA MODULATOR USING ADDITIVE-ERROR SWITCHING" IEEE JOURNAL OF SOLID-STATE CIRCUITS, vol. 31, no. 3, 1 March 1996, pages 284-293, XP000597400
- D. SENDEROWICZ: "Low-Voltage Double-Sampled Sigma Delta Converters" IEEE INTERNATIONAL SOLID STATE CIRCUITS CONFERENCE., 6 - 7 February 1997, NEW YORK US, page 210, 211, 458 XP002052661

## Description

### FIELD OF THE INVENTION

The invention relates to Sigma-Delta analog/digital converters and in particular to a second-order double-sampled Sigma-Delta modulator.

### BACKGROUND OF THE INVENTION

In second-order Sigma-Delta analog/digital converters, briefly ΣΔ A/D, the analog circuital part is essentially based upon a circuit composed of two integrators (because of the second-order) of the switched-capacitor (SC) type in cascade, where the output of the last integrator drives the input of a comparator that realizes, through a one-bit (in the majority of cases) D/A converter, a feedback which has repercussions on the same SC integrators so that these SC integrators process the difference between the input signal and the feedback signal originating from said D/A feedback.

As in all SC circuits a double-sampled structure may be used to save absorbed current. This structure is commonly referred to as a Lossless Discrete Integrator (LDI), realized by simply duplicating each switched-capacitor structure and employing complementary control phases of the switches.

In this way it is possible to attain the same function while halving the clock frequency that drives the switches and, and as a consequence, the current in the operational amplifiers could be reduced considerably because the time at disposal for the settling of the amplifiers themselves is doubled.

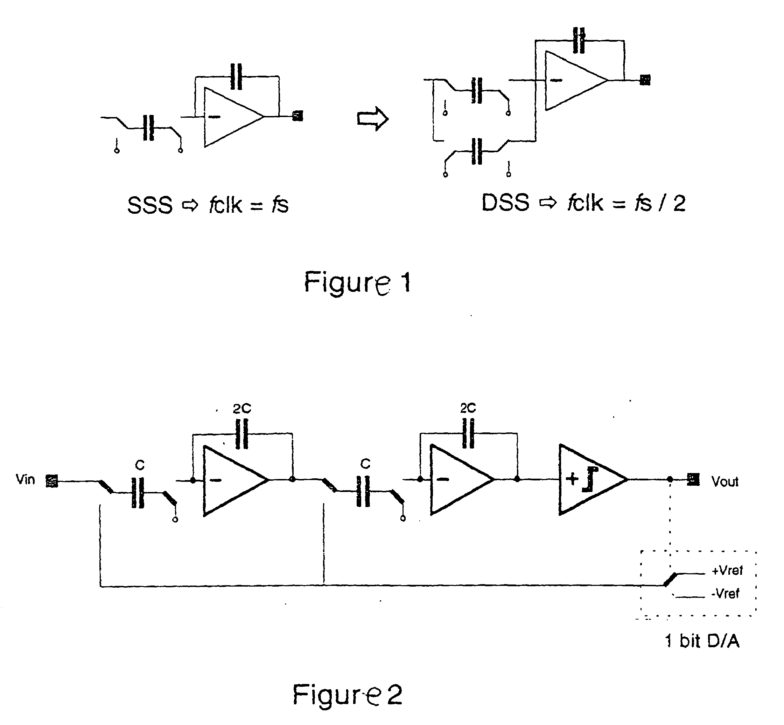

This general concept is illustrated in figure 1.

The document US-A-5 392 043 discloses a second-order double-sampled analog/digital Σ-Δ converter using two differential switch-capacitor integrators coupled in cascade.

The Article "A second-order double-sampled Δ-Σ modulator using additive-error switching", by Burmas T.V. et al, IEEE Journal of Solid State Circuits, Vol. 31, No. 3, 1 March 1996, pages 284-293, XP000597400, describes a second-order double-sampled Δ-Σ modulator using an additive- error switching scheme to convert capacitor mismatch into an additive out-of-band tone that can be easily removed by a digital filter.

The Article "Low-voltage double-sampled ΣΔ converters" by Senderowicz D., IEEE International Solid State Circuits Conference, 6 - 7 February 1997, New York US, pages 210, 211, 458 XP002052661, discloses a double-sampled second-order Σ-Δ modulator and a switched-capacitor demodulating filter.

Instead, figure 2 shows a classical second-order single-sampled ΣΔ modulator. The purpose of this circuit is to assure, in the baseband of the signal to be converted, a satisfactory signal/noise ratio by "shifting" the quantization noise of the converter into a high frequency range. The consequent digital part of the ΣΔ converters will eliminate the high frequency noise by a digital filtering, supplying the data corresponding to the input signal with a resolution (number of bits of the data output by the A/D converter) defined by the signal/noise ratio of the same circuit. The resolution of these A/D converters is determined by the ratio between the clock frequency of the SC circuits and the band of the signal to be converted^{[1]} .
^{[1]} J.C. Candy: *A use of double integration in sigma delta modulation,* IEEE Transaction on Commmucations. Vol. COM-33, No. 3, pp. 249-258, March 1985.

The problem of realizing a second-order ΣΔ modulator using double-sampled SC integrators has been approached in different manners.

The most serious problem of a double-sampled approach is represented by the aliasing of the high frequency quantization noise in the baseband (the band of interest) caused by mismatches among the switched-capacitors that realize the double-sampled structure^{[2]} .
^{[2]} P.J. Hurst. W.J. McIntyre: *Double sampling in switched capacitor delta-sigma A*/*D converters,* in ISCAS proc., pp. 902-905, New Orleans, May 1990.

This aliasing degrades considerably the signal/noise ratio (SNR) of the A/D converter to the point of making not viable the use of a double-sampled structure for the realization of a second-order ΣΔ modulator.

To overcome this problem, a first solution^{[3]} uses a sequential logic which, by considering the "history" of the output signal of the circuit, succeeds in eliminating the aliasing caused by the double-sampled structure, by acting on the switches that realize the feedback in the SC integrators (ΣΔ Modulator with additive-error switching).
^{[3]} T.V. Burmas, K.D. Dyer, P.J. Hurst and S.H. Lewis: *A second-order double-sampled delta sigina modulator using additive-error switching*, IEEE Journal of Solid State Circuits, Vol. SC- 31, pp. 284-293, March 1996.

However, this known circuit is very complex as it increases considerably both the number of switches and of the relative control signals as well as the number of switched-capacitors, with a consequent increase of the area occupied and with the further disadvantage of rendering practically impossible an eventual low supply voltage realization because of too many control signals of the switches to be boosted.

A second known solution^{[4]} eliminates the aliasing of the high frequency quantization noise by realizing a fully floating structure that converts an eventual switched-capacitor mismatch in a common mode signal (Bilinear ΣΔ Modulator).
^{[4]} D. Senderowicz, G. Nicollini, S. Pernici, A. Nagari. P. Confalonieri and C. Dallavalle: *Low- voltage double-sampled* ΣΔ *converters*, in ISSCC Dig. of Tech. paper, pp. 210-211. Feb. 1997.

The main limitation of this known structure is that of requiring the realization of bilinear SC integrators (instead of LDI as in the majority of present architectures), moreover these bilinear SC integrators increment considerably the internal gains of the circuit, with a consequent reduction of the dynamic of the SC integrators and a degrading of the signal to noise ratio (SNR) by about 6 dB.

### PURPOSE AND SUMMARY OF THE INVENTION

Confronted with this state of the art, a structure has now been found capable of eliminating effectively the aliasing of the high frequency quantization noise without substantially increasing the internal gains of the circuit and thereby without degrading the signal to noise ratio figure of a classical architecture.

It has been observed that the aliasing caused by the mismatch of the capacitors of a second-order double-sampled ΣΔ modulator is mainly caused by the capacitors that realize the first SC integrator, that is, the one that directly processes the input signal to be converted.

Surprisingly it has been found that by using, as the second SC integrator in cascade, a classical double-sampled LDI structure as illustrated in figure 1, the SNR of the converter does not degrades appreciably.

Instead, as the first integrator a fully-floating structure, similar to that disclosed in the article [4], is effectively used.

The resulting fully differential structure that exploit the compensation of the error generated by the double-sampled structure of the first integrator by converting such an error signal in a common mode signal and wherein the second integrator is realized in a normal way, has the advantage of reducing the circuit complexity by reducing the number of switched-capacitors, and surprisingly remains perfectly able of controlling the aliasing caused by the double-sampled structure and maintains the same internal gains of the circuit as in a classical ΣΔ modulator (see Figure 2), thus keeping the SNR figure substantially unchanged.

The new ΣΔ modulator could be defined as a semibilinear ΣΔ modulator and is specified in terms of its distinctive aspects in the annexed claims.

### BRIEF DESCRIPTION OF THE DRAWINGS

**Figure 1** is a scheme showing, as already described above, the advantage of passing from a single-sampled switched-capacitor structure to an equivalent double-sampled structure.
**Figure 2** is a functional scheme of a classical second-order ΣΔ modulator used in an analog/digital converter, as already described above.
**Figure 3** is a circuit scheme of a second order semi bilinear bilinear ΣΔ modulator of the present invention.

### DESCRIPTION OF THE CIRCUIT OF THE INVENTION

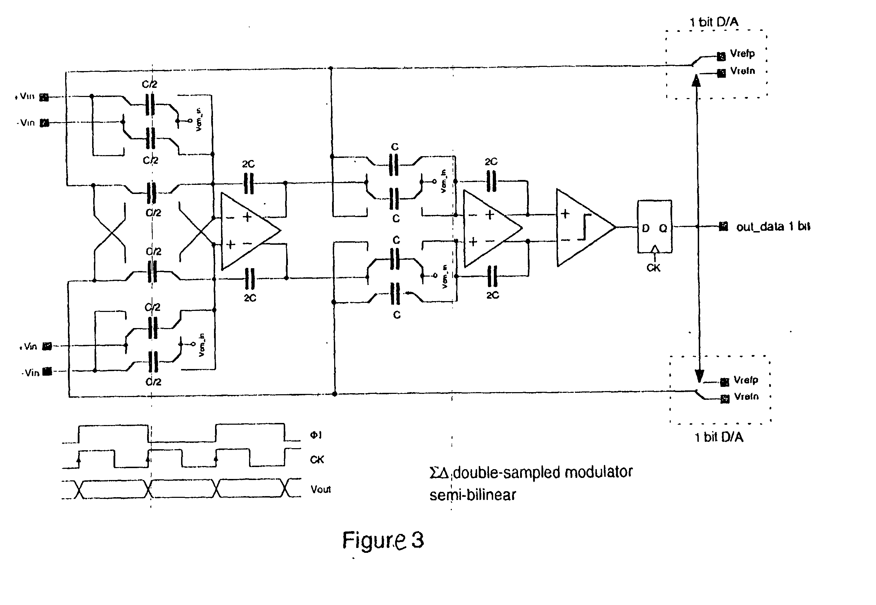

The circuit scheme of a doubled-sampled ΣΔ modulator made according to the present invention is depicted in Figure 3.

The first SC integrating stage presents: a double-sampled bilinear input structure that processes the Vin input signal and dynamically fixes the input common mode voltage of the operational amplifier (because one of the two switches between the switched-capacitor and the inputs of the amplifier is connected to the input common mode voltage (Vcm_in) of the amplifier itself).

Moreover, this structure realizes a fully-floating bilinear structure for processing the feedback signal of the one-bit D/A (represented by the two voltages +Vref or -Vref) and converting the error signal, caused by the mismatch between the two capacitors (C/2) of the first stage in a common mode signal.

By contrast, the second integrating stage is realized according to a classical double-sampled LDI structure that processes both the outputs of the first integrator and the feedback signal produced by the one-bit D/A.

The output of the second SC integrator drives the comparator that performs the one-bit analog/digital conversion and creates, by way of an output latch, the input signal (one-bit out_data) for the feedback D/A.

As may be observed in Figure 3, the gains of the two integrating stages are equal to 1/2, both for the first and for the second integrator because the first integrator realizes a bilinear structure which by itself has an intrinsic gain equal to 2.

Upon comparing the schemes of Figure 3 and Figure 2, it is appreciated how the gains of the two integrators have remained unchanged, thus optimizing the dynamics of the respective operational amplifiers that are used in the two stages and consequently maximizing the SNR figure.

Moreover, the double-sampled ΣΔ semi-bilinear modulator of the invention utilizes a much smaller number of MOS switches than the known circuits, and therefore is suited also for "low-voltage" applications because the signals that need to be boosted are just the classical phases of an SC circuit.

## Claims

1. A second-order double-sampled analog/digital Sigma-Delta converter, composed of two fully differential switched-capacitors integrators in cascade, the first input integrator having a fully-floating double-sampled, bilinear switched capacitor structure, two pairs of differential input nodes of which an analog input signal (+V_{IN}, - V_{IN}) to be double-sampled is applied, the second integrator having a double-sampled loss-less discrete integrator structure, and having negative feedback means of the digital output signal of the converter to an input of the converter, **characterized in that**
said negative feedback means feed said digital output signal of the converter to a third pair of differential input nodes of said first input integrator such to double-sample the feedback digital output signal.

## Patentansprüche

1. Analog-/Digital-Sigma-Delta-Wandler mit doppelter Abtastung zweiter Ordnung, der aus zwei vollständig differentiell aufgebauten Schaltkondensator-Integratoren in Kaskade besteht, wobei der erste Eingangsintegrator eine vollständig schwebende, bilineare Schaltkondensatorstruktur mit doppelter Abtastung aufweist, wobei an zwei Paare differentieller Eingangsknoten von ihr ein analoges Eingangssignal (+VIN, -VIN) angelegt wird, das doppelt abgetastet werden soll, wobei der zweite Integrator eine verlustlose diskrete Integratorstruktur mit doppelter Abtastung aufweist, und eine negative Rückkopplungseinrichtung des digitalen Ausgangssignals des Wandlers zu einem Eingang des Wandlers aufweist, **dadurch gekennzeichnet, daß**
die negative Rückkopplungseinrichtung das digitale Ausgangssignal des Wandlers einem dritten Paar differentieller Eingangsknoten des ersten Eingangsintegrators zuführt, um das rückgekoppelte digitale Ausgangssignal doppelt abzutasten.

## Revendications

1. Convertisseur Sigma-Delta analogique/numérique, à double échantillonnage, du second ordre, constitué de deux intégrateurs à capacité commutée complètement différentiels en cascade, le premier intégrateur d'entrée ayant une structure à capacité commutée bilinéaire, à double échantillonnage, complètement flottant, deux paires de noeuds d'entrée différentiels auxquels un signal d'entrée analogique (+V_{IN}, -V_{IN}) à échantillonner en double est appliqué, le second intégrateur ayant une structure d'intégrateur discret sans perte à double échantillonnage et comportant un moyen de réaction négative du signal de sortie numérique du convertisseur vers une entrée du convertisseur, **caractérisé en ce que** le moyen de réaction négative fournit le signal de sortie numérique du convertisseur à une troisième paire de noeuds d'entrée différentiels du premier intégrateur d'entrée de façon à échantillonner en double le signal de sortie numérique de réaction.
